# FASCICULE DE BREVET EUROPEEN

(11) **EP 0 500 451 B1**
(45) Date de publication et mention de la délivrance du brevet: **07.01.1999**
(21) Numéro de dépôt: 92400426.0
(22) Date de dépôt: 18.02.1992
(51) Int. Cl.: H01L 27/142, H01L 31/18

(54) **Dispositif photovoltaique et module solaire à transparence partielle, et procédé de fabrication**
Photovoltaische Vorrichtung und Solarmodul mit teilweiser Durchsichtigkeit, und Herstellungsmethode
Photovoltaic device and solar module with partial transparency, and fabrication method

(30) Priorité: 21.02.1991 FR 9102075; 22.04.1991 FR 9104927
(43) Date de publication de la demande: 26.08.1992
(73) Titulaire: Phototronics Solartechnik GmbH, 85640 Putzbrunn (DE)
(72) Inventeur: Schmitt, Jacques, F-91620 La Ville du Bois (FR); Ricaud, Alain, F-91190 Gif-Sur-Yvette (FR); Siefert, Jean-Marie, F-94110 Arcueil (FR); Emeraud, Thierry, F-91440 Bures Sur Yvette (FR)
(74) Mandataire: Haft, von Puttkamer, Berngruber, Czybulka

(56) Documents cités:
- EP-A- 0 232 749
- FR-A- 2 594 597
- US-A- 4 243 432
- US-A- 4 542 255
- US-A- 4 663 494
- US-A- 4 795 500
- 18TH IEEE PHOTOVOLTAIC SPECIALISTS CONFERENCE (LAS VEGAS, NV, US) 25 Octobre 1985, IEEE, NEW YORK, US pages 435 - 440; G.C.DE SALVO ET AL.: 'An optimized top contact design for solar cell concentrators'
- PATENT ABSTRACTS OF JAPAN vol. 9, no. 126 (E-318)31 Mai 1985 & JP-A-60 014 474 ( MATSUSHITA ) 25 Janvier 1985
- J.P.HOLMES 'The Electrochemistry of Semiconductors' 1962 , LONDON

## Description

L'invention se rapporte aux structures de type photovoltaïque ayant une caractéristique de transparence partielle combinant les fonctions traditionnelles d'une cellule solaire générant un courant électrique avec celles d'un panneau laissant partiellement passer la lumière, de telles structures trouvant leur application en tant que modules et cellules solaires en couches minces, mais également en tant que panneaux à transparence partielle utilisables sur des toits d'automobile, de bateau ou encore dans le domaine du bâtiment pour la réalisation de portes, fenêtres, vérandas, ...

Bien entendu, ce concept de 'transparence partielle est déjà utilisé dans la vie courante, par exemple lorsque l'on place à l'endroit d'une ouverture exposée au soleil, un store, une persienne, ou toute autre paroi ajourée ayant pour fonction d'occulter partiellement la lumière tout en gardant malgré tout certaines parties transparentes à cette lumière.

L'invention envisage d'appliquer ce principe à des dispositifs assimilables à des structures photovoltaiques en ce qu'ils comwennent un empilement de couches minces couramment utilisés dans le domaine.

Ainsi l'invention se rapporte particulèrement à un dispositif (cellule) photovoltaïque comprenant :
- un substrat électriquement isolant, transparent
- plusieurs éléments photosensibles en couches minces disposés en pile sur le substrat, ces éléments comprenant une couche métallique opaque à travers laquelle sont ménagées des coupures ou ouvertures pour laisser la lumière pouvant être reçue parle dispositif traverser cette couche, permettant ainsi d'assurer à ce dispositif la transparence partielle recherchée, (les autres couches étant en effet si nécessaire suffisamment fines pour se laisser traverser par cette lumière).

Un tel dispositif est connu du document US-A-4 795 500 qui propose dans la couche métallique opaque des trous en forme circulaire, triangulaire, rectangulaire, hexagonale ou tout en général polygonale pour rendre le dispositif semitransparent.

Des tests ont toutefois montré que, notamment lorsqu'un tel dispositif est utilisé en tant que cellule solaire, réaliser les coupures de transparence sous la forme de trous ou d'orifices non allongés et fermés périphériquernent risque parfois d'induire des perturbations dans la circulation des lignes de courant, les lignes qui rencontrent les trous étant déviées par ces derniers qui forment obstacles à une circulation par nappes homogènes des lignes de courant.

Une conformation des coupures en tranchées (même à contour fermé) allongées dans une direction transversale de la cellule perpendiculaire à l'épaisseur de la couche considérée et orientées avantageusement dans le sens de circulation desdites lignes de courant doit limiter ce problème, la cellule présentant alors au moins partiellement une structure de couches en bandes.

Cela étant, il s'est avéré que les risques de court-circuits pouvaient demeurer non négligeables dans certaines conditions, à l'occasion d'un défaut de bord.

C'est pourquoi, un objet supplémentaire de l'invention est de proposer un dispositif photovoltaïque en couches minces dont les risques de court-circuits entre couches sont largement limités.

Pour cela. il est proposé "d'ouvrir" lesdites tranchées à leurs extrémités longitudinales opposées, de manière que la structure en bandes de la couche conductrice opaque au moins, s'étende continûment d'un bord latéral au bord opposé de chaque dispositif.

Sur une cellule solaire, une orientation convenable de ces tranchées favorisera la circulation par nappe homogène des lignes de courant, étant donné que les tranchées en question diviseront la partie active de la cellule en autant de zones actives non topologiquement connexes (à la différence des trous ou toute autre forme à contour fermé).

Une structure pareille à première vue est connue du document US-A-4 542 255 qui présente également des tranchées allongées dans la couche métallique opaque. Toutefois, cette mesure a uniquement pour objet de compenser certains désavantages provoqués par des bandes métallique étroites formées justement au-dessous de ces tranchées à la surface de la couche conductrice transparente. Ces bandes métalliques détériorent la semi-transparence du dispositif produite sans intention par lesdites tranchées.

On notera encore que, toujours pour améliorer les conditions d'isolement électrique, une autre caractéristique additionelle de l'invention consiste également à conseiller une réalisation de la couche de conversion photoélectrique (habituellement interposée entre deux couches métalliques respectivement opaque et transparente) de manière qu'elle présente, à l'endroit desdites coupures de transparence, un rebord d'isolement. Avec un tel rebord, on pourra, pour la transparence partielle, recourir quasi indifféremment à des trous à contour fermé ou à des tranchées ouvertes, voire à des solutions intermédiaires.

Outre le dispositif qui vient d'être présenté, il va être décrit un procédé pour réaliser ces interruptions de matière à travers notamment la couche de conversion photoélectrique.

En effet, la réalisation de telles coupures pose un réel problème dans la mesure où il est bien connu de l'homme de l'art qu'une gravure chimique à travers un masque provoque régulièrement une attaque sous-jacente conduisant à la formation d'une bordure de masque surplombante (phénomène souvent dénommé "undercutting").

Or, l'existence d'une telle bordure surplombante augmente nécessairement les risques de court-circuits entre les couches électrodes, en particulier si le masque est constitué par la couche conductrice (ou électrode) arrière la plus éloignée du substrat.

Pour résoudre ce problème, il est proposé, comme il est connu en soi du document FR-A-2 594 597,
a) de réaliser cette couche électrode "arrière", pour qu'elle présente localement, au contact de la couche de conversion photoélectrique, des interruptions de matière formant les coupures précitées,
b) puis, sensiblement dans le prolongement de cesdites coupures, d'enlever sélectivement la couche de conversion photovoltaïque pour qu'en ces endroits cette couche présente elle-même des coupures limitées latéralement par un rebord de matière isolant électriquement lesdites couches conductrices.

Outre cela, l'invention a également tout naturellement pour objet un module solaire "complet" comprenant plusieurs dispositifs ou cellules photovoltaïques élementaires reliés électriquement en série par des zones d'interconnexion série. Si une forme de coupures de transparence en tranchée a été retenue, ces zones d'interconnexion intersecteront, ou borderont ces tranchées, au niveau de deux cellules voisines.

On notera encore que, conformément à une autre caractéristique de l'invention, tant les dispositifs photovoltaïques que les modules solaires seront avantageusement tels que l'oeil humain puisse voir ou distinguer assez précisément une forme à travers, la largeur des bandes de matière séparées par lesdites coupures de transparence étant avantageusement de l'ordre de 2 mm.

Bien entendu, toutes les caractéristiques susmentionnées s'appliquent également lorsque le dispositif photovoltaïque de l'invention n'est pas particulièrement utilisée pour ses performances photoélectriques, mais plus spécifiquement pour ses caractérisitiques de transparence partielle (par exemple sur une façade d'immeuble), la collecte du courant photogénéré pouvant alors n'être pas effectuée.

Toutefois la description qui va suivre sera essentiellement faite, par souci de clarté, en référence aux cellules et modules solaires.

Dans les dessins d'accompagnement :
- la figure 1 est une vue schématique en coupe transversale d'une cellule photovoltaïque élémentaire conforme à l'invention,
- la figure 2 est une vue en plan de la partie d'une partie de la cellule de la figure 1, dans le sens de la flèche F' de cette figure,
- les figures 3 et 4 montrent chacune schématiquement, suivant une vue locale en plan et dans le sens de la flèche F de la figure 5, un exemple de réalisation d'une zone appartenant à la surface photoélectriquement active d'une cellule du type de celle de cette figure 1,
- la figure 5 est une vue en coupe selon la ligne de coupe V-V de la figure 4,
- la figure 6 est une vue schématique en plan d'un module solaire conforme à l'invention comprenant une série de cellules élémentaires connectées en série,
- la figure 7 est une vue locale en coupe transversale selon la ligne VII-VII de la figure 6,
- les figures 8 et 9 sont deux vues schématiques partielles en plan de deux variantes de réalisation du module illustré sur la figure 6,
- la figure 10 est une vue locale schématique en coupe transversale selon la ligne X-X de la figure 9,
- la figure 11 est une vue schématique partielle en plan d'une autre variante de réalisation d'un module solaire conforme à l'invention.
- la figure 12 illustre, suivant une vue schématique en plan, un module solaire à échelle réduite présentant sur toute sa périphérie une tranchée d'isolation conforme à l'invention,
- la figure 13 est une vue locale en coupe transversale selon la ligne XIII-XIII des figures 2, 3 ou 4,
- la figure 14 montre en coupe schématique transversale la tranchée d'isolation de la figure 12 à l'endroit du détail repéré XIV sur cette même figure 12,
- les figures 15A, 15B, 15C, 15D et 15E montrent également schématiquement, suivant une coupe transversale, les principales étapes d'un procédé de réalisation pouvant être suivies pour réaliser la tranchée périmétrique d'isolation des figures 12 et 14,
- la figure 16 montre, en coupe transversale, une couche de conversion photovoltaïque en train d'être gravée chimiquement,
- et les figures 17A, 17B, 17C et 17D illustrent schématiquement, en coupe locale transversale, les principales étapes pouvant être suivies pour réaliser la structure de la figure 13.

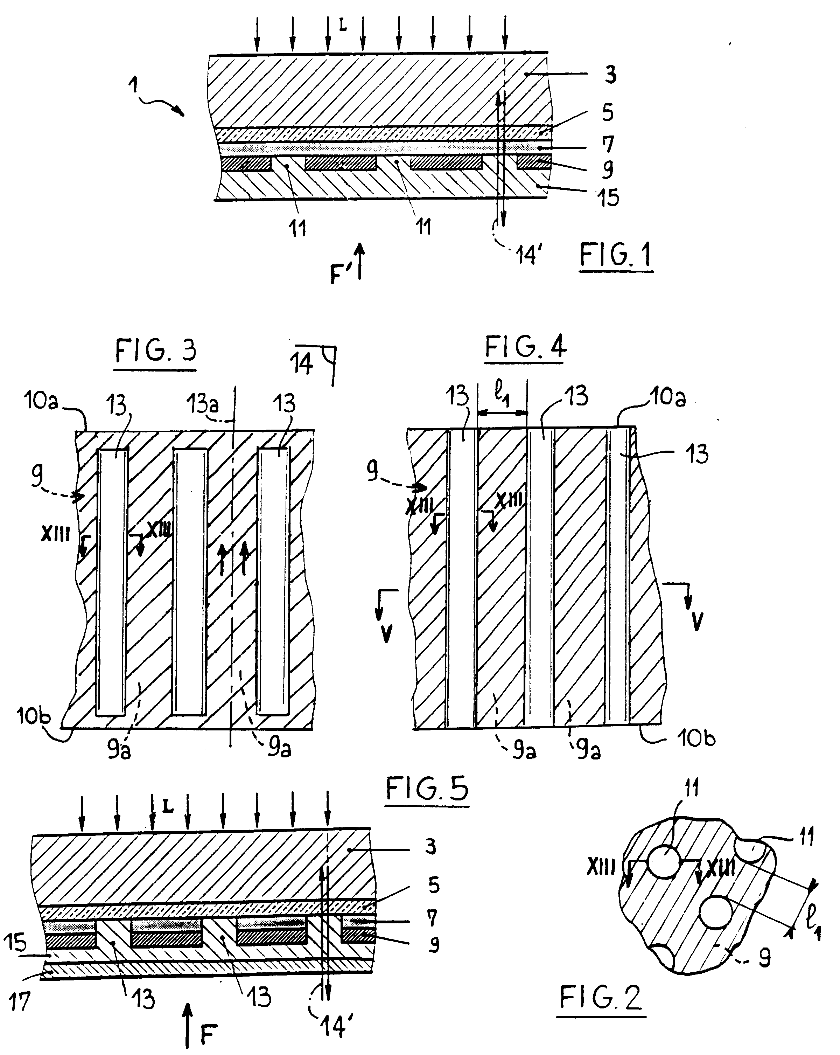

Sur la figure 1, on voit donc tout d'abord illustré un détail d'un dispositif photovoltaïque 1, réalisé suivant la technique dite "des couches minces".

De façon classique, le dispositif en question comprend une série de couches minces 5, 7, 9 formant éléments photosensibles empilés sur un substrat support 3 électriquement isolant et transparent.

Le substrat 3 prévu pour recevoir en premier la lumière incidente L d'éclairement principal de la cellule peut être réalisé par exemple en verre ou en matière polymère.

Les couches minces qui le surmontent comprennent successivement une couche 5 servant d'électrode avant (par exemple réalisée en oxyde transparent conducteur, TCO) de quelques centaines de mm d'épaisseur déposée sur le substrat, une couche semi-conductrice 7 assurant la conversion photovoltaïque et, surmontant cette dernière, une couche 9 servant d'électrode arrière, elle-même recouverte d'au moins une pellicule transparente et électriquement isolante de protection 15.

L'électrode "arrière" 9 pourra notamment être réalisée en métal ou avec des empilements de couches métalliques, et être opaque. Mais on pourrait également envisager d'inverser la structure en réalisant celle-ci avec une électrode arrière en TCO (tel par exemple que du SnO₂, ITO, ZnO...) et une électrode avant 5 métallique, opaque.

Dans ce qui suit on ne traitera toutefois que du cas, jugé ici préférable, d'une électrode avant 5 transparente et d'une électrode arrière 9 en matière opaque.

Quant à la couche de conversion photovoltaïque 7, elle pourra, selon une technique classique, être par exemple réalisée par stratification successive de trois sous-couches p-i-n, chacune de ces sous-couches étant constituée à partir d'un matériau semi-conducteur approprié tel par exemple que le silicium amorphe hydrogéné.

Pour assurer à une telle cellule, la transparence partielle recherchée, plusieurs solutions peuvent être adoptées dans la conformation des coupures ou ouvertures devant traverser l'électrode opaque afin de laisser des passages à la lumière.

Tout d'abord, on peut réaliser dans cette électrode des orifices ou trous à contour fermé.

C'est la solution illustrée figures 1 et 2.

Sur la figure 1, les orifices 11 traversent donc l'électrode arrière opaque 9.

Il s'est toutefois avéré que la présence de tels trous ne favorisait pas la circulation des lignes de courant et risquait d'augmenter partiellement les risques de court-circuits entre les couches-électrodes 5 et 9.

Après de nombreux essais infructueux, une première solution de remplacement, jugée préférable et illustrée figure 3, a été trouvée dans la réalisation de tranchées continues 13, allongées suivant une direction transversale dans la surface générale 14 de la cellule, et ceci contenue de préférence sensiblement parallèlement à la direction 13a des lignes de courant cheminant dans l'électrode 9, ces tranchées s'étendant d'ailleurs avantageusement jusqu'à proximité des deux bords ou côtés opposés 10a, 10b de ladite cellule.

Pour limiter encore les risques de court-circuits, une seconde solution est également apparue consistant, comme illustrée figure 4, à faire déboucher longitudinalement les tranchées.

Ainsi conformée, l'électrode opaque 9 se présentera alors sous la forme d'une série de bandes 9a, électriquement conductrices s'étendant continûment entre les côtés opposés précités 10a, 10b de chaque cellule élémentaire, une bande étant continûment séparée ou isolée de la bande voisine par une tranchée "transparente", continue 13 formée à travers toute l'épaisseur d'au moins l'électrode 9 et débouchant ou s'ouvrant donc longitudinalement, sur la figure 4, de part et d'autre, sur lesdits côtés 10a, 10b.

Sur la figure 5, on remarquera que les tranchées 13 formées, non seulement à travers l'électrode arrière 9, mais également à travers la couche semi-conductrice 7 et sont remplies par la couche isolante de protection 15, de préférence neutre du point de vue des couleurs, laquelle est elle-même recouverte d'une feuille ou plaque également transparente et isolante de protection complémentaire 17, plus rigide, par exemple en verre ou en polymétacrylate de méthyl.

Eventuellement, on pourrait même imaginer un enlèvement comparable de matière (par bandes) de l'électrode avant transparente 5.

Bien entendu, une telle découpe des couches 7 aurait également pu être prévue dans le cadre des figures 1 et 2, par prolongement des trous à travers la ou les couche (s) sous-jacente(s).

D'une façon générale, le but de la "tranparence partielle" n'étant pas tant de laisser passer la lumière incidente à travers chaque cellule que de permettre à une personne de pouvoir voir ou distinguer une forme à travers, notamment en sens inverse (flèche 14' des figures 1 et 5), on peut raisonnablement estimer que pour qu'une image puisse être vue par un oeil humain dans l'essentiel de ces détails, sans réduire excessivement le rendement électrique de la cellule, la largeur l₁ des espaces ou bords entre coupures (tels que 9a sur la figure 4) ne devra pas excéder environ 2 à 2,5 mm, au moins sur la partie centrale active de la cellule, avec une répartition de préférence sensiblement régulière des coupures.

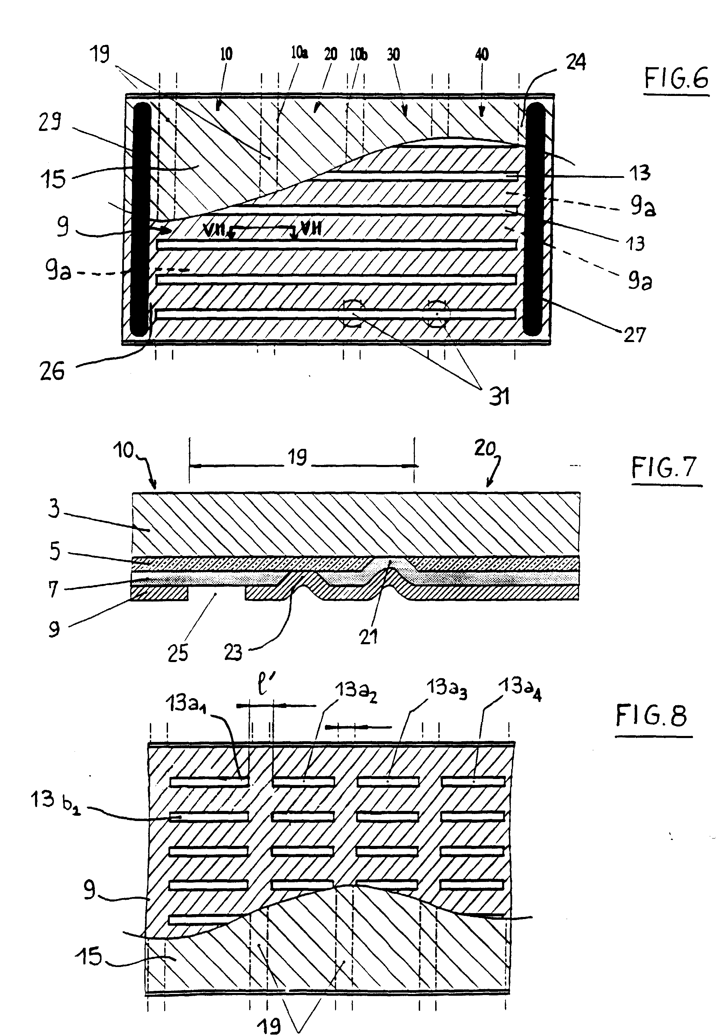

Reportons-nous maintenant aux figures 6 à 11 pour voir illustré un module photovoltaïque constitué d'une série de cellules solaires élémentaires pouvant être de l'un des types de celles des figures précédentes, ces cellules étant associées en série à la suite les unes des autres.

Sur la figure 6, on a illustré partiellement un tel module comprenant quatre cellules solaires élémentaires 10, 20, 30, 40 reliées deux à deux, sur leurs côtés latéraux, tels que 10a, 10b pour la cellule 20, par des bandes d'interconnexion série schématisées par les zones 19.

Plusieurs techniques peuvent être utilisées pour ces connexions. Le brevet US-A-4 243 432 décrit une possibilité dont le principe a été illustré sur la figure 7 où l'on peut voir une bande ou zone d'interconnexion 19 constituée de trois zones parallèles et sensiblement adjacentes : une zone 21 d'interruption de l'électrode avant 5 où la couche de conversion photovoltaïque 7 d'une cellule vient directement au contact du substrat 3, une zone de percement ou d'interruption 23 de cette même couche semi-conductrice où l'électrode arrière 9 vient directement au contact de l'électrode avant 5 d'une cellule voisine, puis une autre zone d'interruption 25 de l'électrode arrière 9.

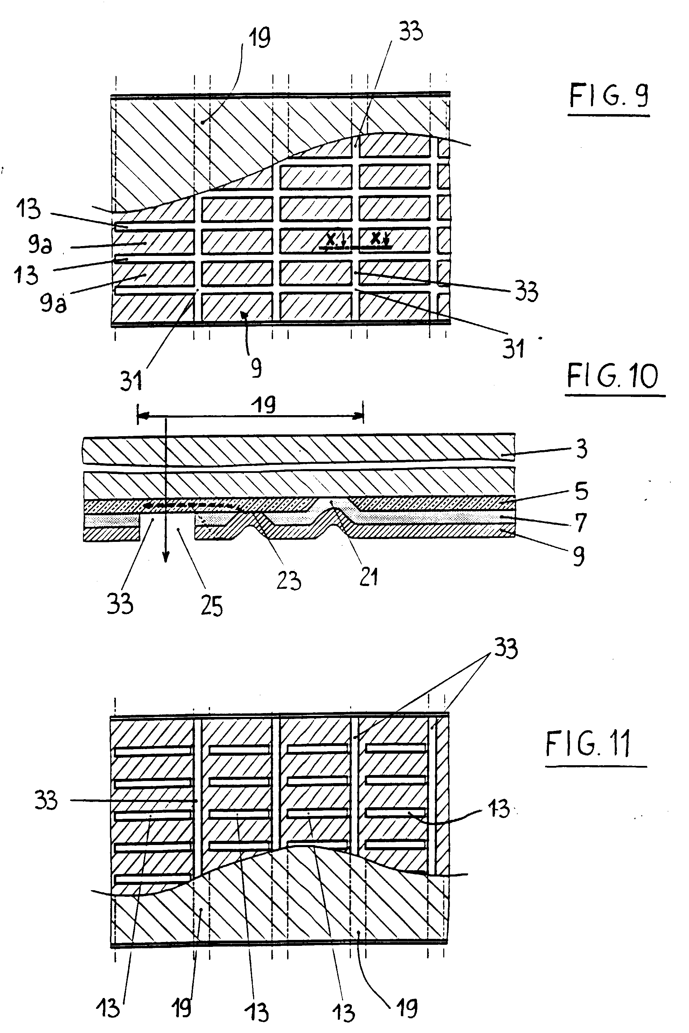

On notera qu'une manière aisée de réaliser un tel module en intégrant la semi-transparence "en bandes" pourra consister à orienter les bandes 9a de chaque cellule élémentaire sensiblement perpendiculairement à la direction des bandes 19 d'interconnexion série, en découpant (par exemple par gravure avec enlèvement de matière) les tranchées 13 à travers la ou les couche(s) considérée(s), ceci sur l'essentiel de la longueur du module (comme illustré sur les figures 6 et 9). Il suffira ensuite de reconnecter de manière classique toutes les bandes entre elles sur les côtés latéraux opposés 24, 26 du module, et d'aménager les zones de reprise de contact 27, 29 comme illustré figure 6, avec branchement des câbles de connexion électrique (non représentés).

Cette technique ne présente aucune difficulté réelle , sauf éventuellement si la réalisation des tranchées 13 ouvertes à leurs extrémités interfère avec la formation des bandes 19, à l'endroit de leurs intersections, telles que repérées 31 sur les figures 6 et 9.

En particulier dans ce cas, on peut recourir à la géométrie de la figure 8 où le module illustré est constitué d'une série de cellules élémentaires du type de celle de la figure 4 avec des tranchées 13 non débouchantes et se présentant, par ligne, sous la forme de tronçons 13a1, 13a2,..., 13a4, 13b1..., les interruptions se situant aux endroits des bandes d'interconnexion 19, la largeur l' entre deux tronçons de tranchées consécutifs d'une même ligne pouvant être d'environ 0,5 à 2 mm (a priori supérieure ou égale à la largeur des bandes 19).

Bien entendu, ces caractéristiques valent également pour la variante de réalisation de la figure 11 où l'on retrouve une réalisation par tronçons et en lignes des tranchées.

La particularité de la géométrie illustrée sur cette figure 11, ainsi d'ailleurs que sur la figure 9, est dûe à ce que l'on a ici cherché à augmenter encore le taux de semi-transparence en créant le long des bandes d'interconnexion série, des tranchées transparentes complémentaires repérées 33 pouvant s'étendre perpendiculairement aux tranchées "élémentaires" 13.

La réalisation de ces tranchées complémentaires 33 est illustrée en coupe sur la figure 10 où il apparaît que dans le jeu des trois rayures 21, 23, 25, la coupure 25 de l'électrode arrière 9 peut devenir transparente, à condition que la coupure 33 soit faite à travers la couche semi-conductrice 7, ceci dans la continuité de la coupure 25, à l'endroit des bandes d'interconnexion série 19.

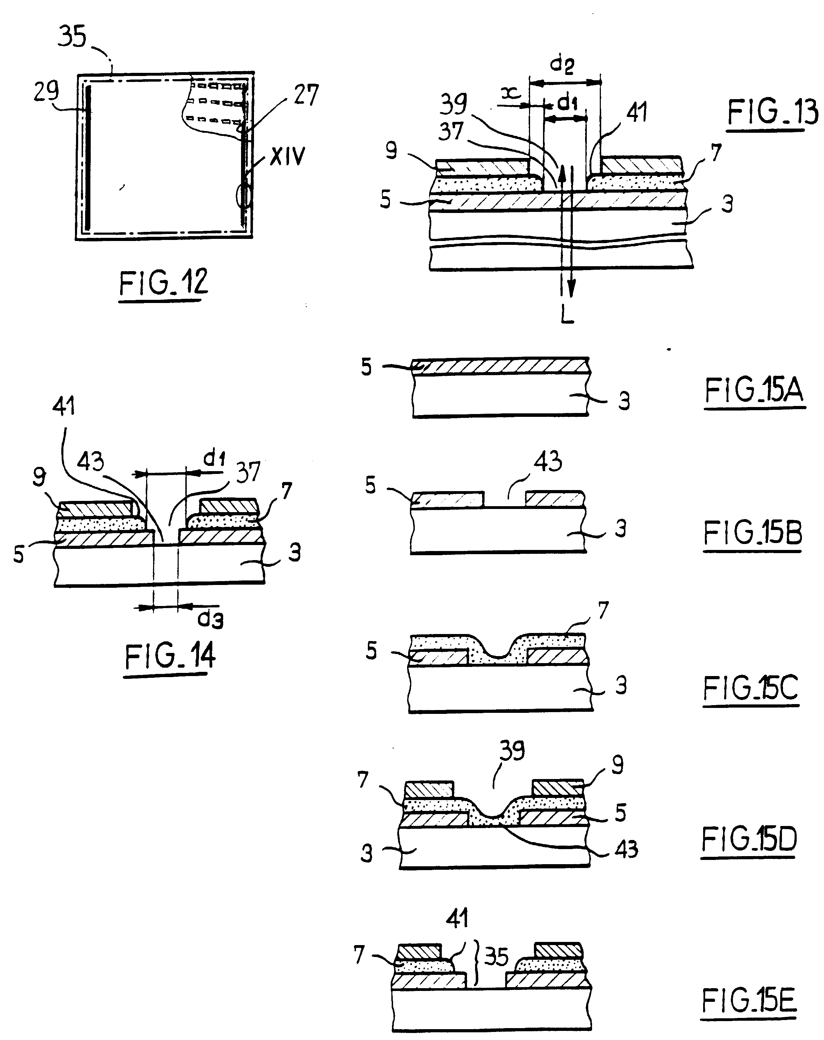

Intéressons-nous maintenant aux figures 12 à 17D pour décrire plus en détail une autre amélioration proposée par l'invention toujours dans le cadre de la limitation des problèmes de court-circuits, que ceux-ci surviennent à l'endroit des coupures de transparence 11, 13 ou à proximité de la bordure périmétrique 35 d'un module complet, comme illustré sur la figure 11.

Que ce soit donc sur un dispositif photovoltaïque classique ou à transparence partielle, la solution proposée en l'espèce consiste à ménager, à l'endroit de toute coupure faite à travers la couche de conversion photovoltaïque 7, une avancée de matière débordant vers l'intérieur de la coupure considérée et formant ainsi un rebord d'isolation électrique entre les couches électrode 5 et 9.

C'est d'ailleurs pourquoi la coupure 37 de la figure 13 formée dans la couche photovoltaïque 7 présente une dimension transversale (ou une section) d₁ inférieure à la dimension transversale d₂ de la coupure 39 sur-jacente précédemment formée à travers la couche électrode supérieure 9.

Pour accroître la fiabilité des résultats, on conseillera de réaliser le rebord 41 ainsi formé de manière qu'il s'étende continûment le long de toute la bordure de chaque coupure considérée.

A partir des essais qui ont été menés, il a été remarqué que des résultats favorables étaient obtenus lorsque les rebords 41 présentaient une largeur x comprise entre environ 5 à 50 µm (microns).

On notera toutefois que si la coupure doit être réalisée pour former la tranchée périmétrique continue 35 assurant l'isolation électrique de la partie active d'un module par rapport à sa bordure extérieure, la rayure ou coupure 43 qui aura été formée à travers la première couche électrode 5 présentera de préférence une dimension transversale d₃ (ou section) inférieure à celle d₁ de la coupure 37 faite à travers la couche qui la surmonte (voir figure 14). Ainsi, on obtiendra une tranchée d'isolement triple à bords en marches d'escalier.

Pour réaliser de telles interruptions de matière, on procèdera globalement de manière classique, en ménageant d'abord les coupures à travers toute l'épaisseur de la couche électrode arrière 9, puis en venant enlever sélectivement sensiblement dans le prolongement desdites coupures, la couche de conversion photovoltaïque 7, par exemple par une gravure chimique.

Pour plus de détails, intéressons-nous tout d'abord à la façon de réaliser la coupure d'isolement périmétrique 35 de la figure 12.

Pour cela, reportons-nous d'abord à la figure 15A, où l'on voit que l'on viendra en premier lieu déposer (par exemple par pulvérisation cathodique sous vide partiel) la première couche électrode 5 sur une face du substrat 3.

On pourra alors procéder à la réalisation, à travers l'électrode 5, de la tranchée périmétrique "de base" 43, amorce de ladite coupure d'isolement (figure 15B).

Pour ce faire, on pourra effectuer une ablation par laser avec une longueur d'ondes de faisceau de l'ordre de 1,06 nm pour une couche de SnO₂ d'environ 600 nm d'épaisseur, la tranchée 43 pouvant avoir sur la périphérie du module considéré une largeur d₃ de quelques dizaines à quelques centaines de microns.

Après cela, on va pouvoir déposer sur cette couche à tranchée périphérique la couche de conversion photovoltaïque 7, telle qu'une couche de silicium amorphe de 200 à 400 nm (figure 15C).

Après quoi, le dépôt de la couche métallique formant l'électrode 9 pourra être effectué par dessus la couche 7.

Pour obtenir les coupures souhaitées à travers l'électrode 9, et ceci bien entendu dans le prolongement vertical de la tranchée 43, il est conseillé d'abord de venir déposer continûment la couche (ou les sous-couches) de matière, puis de graver sélectivement l'électrode en regard de ladite tranchée 43, par exemple par évaporation ou pulvérisation cathodique à travers un masque métallique adapté.

Mais on pourrait également recourir à une technique dite de révélation (ou de "patterning by lift off") mentionnée notamment dans les publications US-A-4 443 651 ou JP-A-611 098 686.

Quoi qu'il en soit, la tranchée formée à travers la couche 9 aura de préférence une largeur supérieure à celle de la tranchée 43 de la couche 5 (figure 15D).

Parvenu à cette étape il restera à retirer sélectivement la couche de conversion 7 entre les deux tranchées 39 et 43, en ménageant les rebords d'isolement 41 (voir figures 14 et 15E).

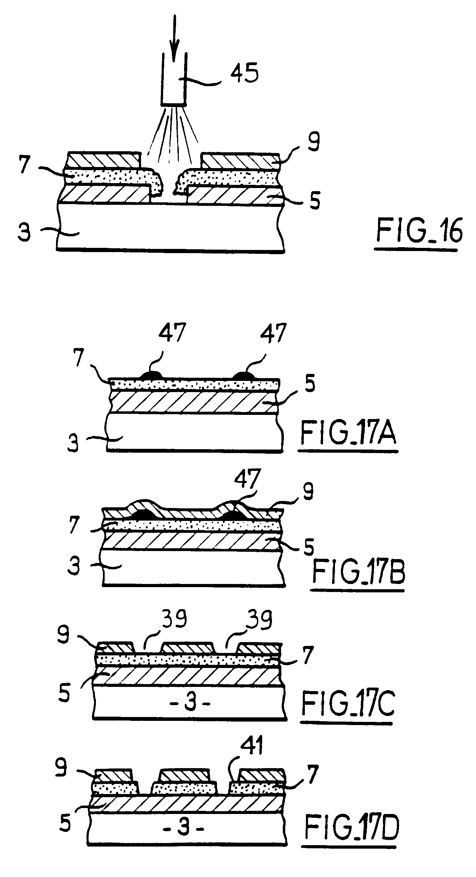

Pour cela, on utilisera avantageusement la gravure chimique. Plus précisément, et notamment dans le cas d'une couche 7 à base de silicium amorphe et en présence d'une électrode arrière 9 à base d'un métal inoxydable résistant à la soude, on recourra avantageusement à l'utilisation d'une lessive de soude que l'on pourra notamment pulvériser ou projeter en phase liquide sur la couche semi-conductrice, aux endroits des coupures, ceci à partir par exemple de buses de pulvérisation telles que 45 (figure 16).

On pourra en particulier utiliser une lessive de soude concentrée entre environ 5 et 40 % portée à une température de 45 à 65° C et prévoir une durée d'attaque de quelques minutes.

il est à noter que cette opération ne nécessite aucun masquage particulier de la face arrière du module, ce qui serait très délicat à réaliser compte tenu des dimensions habituelles de gravure à effectuer.

On obtient ainsi la structure de la figure 15E (identique à celle de la figure 14).

Hormis la réalisation initiale de la coupure périphérique 43 à travers la première couche électrode 5, la technique qui vient d'être présentée est tout à fait applicable à la réalisation d'un dispositif photovoltaïque à transparence partielle, et ceci au niveau de chaque cellule élémentaire.

Pour plus de clarté, on a d'ailleurs représenté sur les figures 17A à 17D les principales étapes de réalisation d'une telle structure.

Sur ces figures, on remarquera notamment, en ce qui concerne les figures 17A et 17B que l'on a illustré le cas (parmi d'autres) où l'ablation locale de la couche métallique 9 est réalisée par "lift off" (révélation), c'est-à-dire en l'espèce par dépôt, aux endroits où l'on désire réaliser les passages 11 ou 13 utiles à la semi-transparence, d'une pâte 47 adhérante mais pelable, ceci sur la couche de conversion photovoltaïque 7 préalablement déposée, ces motifs de pâte de révélation étant ensuite recouverts, tout comme l'ensemble de la couche 7, par la couche électrode arrière 9 (voir figure 17B), la technique précitée du "lift off" permettant ensuite, par révélation, le retrait de cette pâte et du métal qui la surmonte, là où la pâte a été déposée, assurant ainsi l'obtention des motifs de coupure 39 illustrés sur la figure 17C. Il ne reste plus alors qu'à conduire la gravure chimique à la lessive de soude de la couche de conversion photovoltaïque sous-jacente 7 pour obtenir les motifs de semi-transparence désirés avec leur bordure 41 d'isolement électrique (voir figure 17D).

Même si la nature de la couche semi-conductrice 7 est relativement importante, il doit être clair que l'on pourrait la réaliser avec une structure n-i-p, voire avec une jonction p/n ou autres, et ceci à partir d'autres semiconducteurs, tels que CuInSe₂, CdS, CdTe, ou GaAs, la nature de la solution utilisée pour sa gravure étant alors adaptée en conséquence.

Il pourrait également être intéressant de réaliser conformément à l'invention une structure du type "tandem", c'est-à-dire une structure aujourd'hui classique comprenant un double empilement de couches minces, séparées ou non par une couche électriquement isolante tranparente de liaison.

On notera enfin, puisque l'invention s'applique également, au delà de la réalisation de cellules et modules solaires, à la fabrication de panneaux partiellement transparents à la lumière pour des façades d'immeubles, toits de voitures, vérandas, ... que la structure de tels panneaux pourra correspondre à celle illustrée aux figures 6 ou 8. Si la transmission de courant électrique photogénéré n'est plus nécessaire, les bornes électriques 27, 29 pourront être supprimées et les bandes d'interconnexion 19 supprimées. Pour revêtir le substrat 3 de ses couches fines photosensibles (couches conductrices opaque et transparente 5, 9 et couche semi-conductrice 7), les mêmes procédés pourront être employés : procédé par plasma C V D, et/ou pulvérisation cathodique à magnétron, par exemple. Quant aux coupures ou tranchées 11, 13, elles pourront également être réalisées par pulvérisation cathodique ou par "lift off". Le brevet US-A-4 443 651 décrit une technique de revêtement, de même que le brevet US-A-4 795 500 qui enseigne en plus la réalisation de coupures de transparence dans un dispositif photovoltaïque.

## Revendications

1. Cellule photovoltaique comprenant:
- un substrat (3) électriquement isolant, transparent,
- un empilement de couches minces disposés en pile sur le substrat, comprenant une couche métallique transparente (5), une couche semi-conductrice de conversion photovoltaique (7) et une couche métallique opaque (9) à travers laquelle sont ménagées des ouvertures (11, 13) pour laisser la lumière traverser cette couche,
- caractérisé en ce que lesdites ouvertures (11, 13) présentent une forme de tranchée, ces tranchées ménageant entre elles des bandes de matière (9a) de la couche métallique opaque,
- et en ce que lesdites tranchées (13) s'étendent longitudinalement sensiblement dans la direction (13a) des lignes de courant photogénérées circulant dans ladite couche métallique opaque (9).

2. Cellule selon la revendication 1 caractérisé en ce que lesdites tranchées s'étendent sensiblement parallèlement les unes aux aubes, continûment, jusqu'à proximité de deux bords opposés (10a, 10b) de la cellule.

3. Cellule selon la revendication 1 caractérisé en ce que lesdites tranchées (13) présentent deux extrémités longitudinales opposées qui débouchent respectivement sur un premier bord (10a) et un second bord (10b) opposé de cette cellule, divisant ainsi au moins ladite couche métallique opaque (9) en une série de bandes continues (9a).

4. Cellule selon l'une des revendications précédentes caractérisé en ce que lesdites ouvertures (11, 13) s'étendent à travers la couche semi-conductrice(7).

5. Cellule selon la revendication 1 caractérisé en ce que lesdites ouvertures de transparence (11, 13) sont formées à travers ladite couche métallique opaque (9) et, sensiblement dans le prolongement, à travers ladite couche de conversion photovoltaïque (7), laquelle présente, à l'endroit desdites ouvertures, un rebord (41) favorisant l'isolation électrique entre lesdites couches métalliques respectivement transparente et opaque (5, 9).

6. Cellule selon la revendication 5 caractérisé en ce que ledit rebord d'isolation (41) qui forme une avancée vers l'intérieur de l' ouverture (11, 13) consdérée, s'étend continûment le long de toute la bordure de celle-ci.

7. Cellule selon l'une des revendication 5 ou 6 caractérisé en ce que le rebord d'isolation (41) présente une largeur comprise entre 5 et 50 microns environ.

8. Cellule selon la revendication 1 dans laquelle ladite couche de conversion photovoltaïque (7) est réalisée à base de silicium amorphe et ladite couche métallique opaque comprend un métal inoxydable résistant à la soude.

9. Module solaire comprenant plusieurs cellules photovoltaiques élémentaires (10, 20, 30, 40) selon l'une des revendications 1 à 8 reliées électriquement en série à l'endroit de zones d'interconnexion série (19).

10. Module selon la revendicaion 9 dans lequel lesdites zones de connexion série (19) qui relient en série lesdites cellules élémentaires (10, 20...) s'étendent transversalement à ladite (auxdites) direction(s) dans laquelle (lesquelles) sont orientées longitudinalement les tranchées (13).

11. Module selon la revendication 9 dans lequel lesdites tranchées s'étendent, par cellule, jusqu'à proximité de deux bords opposés (10a, 1 Ob) de la cellule considérée.

12. Module selon l'une des revendications 9 ou 10 dans lequel lesdites tranchées (13) présentent deux extrémités longitudinales opposées qui débouchent respectivement sur un premier bord (10a) et un second bord (10b) opposé de chaque cellule.

13. Module selon l'une des revendication 9 à 12 dans lequel la distance (I₁) entre deux dites ouvertures (11, 13) voisines est inférieure ou égale à 2 mm ou 2,5 mm environ, pour qu'un oeil humain pusse voir sensiblement distinctement à travers le module.

14. Module selon la revendication 9 dans lequel lesdites tranchées de transparence (13) de deux cellules élémentaires voisines communiquent entre elles deux à deux, en ligne.

15. Module selon l'une des revendications 9 à 14 caractérisé en ce qu'il comprend également des tranchées de transparence complémentaire (33) s'étendant transversalement auxdites tranchées (13) des cellules élémentaires, le long de certaines au moins des zones d'interconnexion série (19) en forme de bandes, ces tranchées complémentaires étant formées, dans le sens de l'épaisseur du module, à travers la couche semi-conductrice de conversion photovoltaïque (7), dans la continuité d'une autre coupure formée à travers la couche métallique opaque (9) pour la liaison en série des cellules.

16. Module selon l'une des revendications 9 à 14 comprenant une tranchée périphérique continue (35) d'isolement électrique du module vis-à-vis de ses bords, ladite tranchée périphérique étant formée à travers non seulement ladite couche métallique opaque (9), mais également à travers la couche semi-conductrice de conversion photovoltaïque (7) disposée au contact de cette couche opaque (9), ainsi que, sensiblement dans le prolongement, à travers la couche métallique transparente (5) disposée au contact de ladite couche de conversion photovoltaïque, avec un rebord d'isolement électrique (41) au niveau de la portion de tranchée ménagée à travers cette couche de conversion photovoltaïque, dans le but de renforcer l'isolement électrique entre lesdites couches métalliques (5, 9).

## Patentansprüche

1. Photovoltaische Zelle, umfassend
- ein elektrisch isolierendes transparentes Substrat (3),
- einen auf das Substrat gestapelten Stapel von dünnen Schichten, umfassend eine transparente metallische Schicht (5), eine photovoltaische Halbleiterumwandlungsschicht (7) und eine opake metallische Schicht (9), durch die Öffnungen (11, 13) gebildet sind, um das Licht durch diese Schicht hindurchtreten zu lassen,
- dadurch gekennzeichnet, dass die besagten Öffnungen (11, 13) grabenförmig ausgebildet sind, wobei zwischen den Gräben Streifen aus dem Material (9a) der opaken metallischen Schicht gebildet sind,
- und dass die besagten Gräben (13) sich im wesentlichen längs in Richtung (13a) der Linien des photoerzeugten Stromes erstrecken, der in der besagten opaken metallischen Schicht (9) fließt.

2. Zelle nach Anspruch 1, dadurch gekennzeichnet, dass die besagten Gräben sich im wesentlichen parallel zueinander kontinuierlich bis zur Nähe der beiden gegenüberliegenden Seiten (10a, 10b) der Zelle erstrecken.

3. Zelle nach Anspruch 1, dadurch gekennzeichnet, dass die besagten Gräben (13) zwei gegenüberliegende Längsenden aufweisen, die in eine erste Seite (10a) bzw. eine gegenbüberliegende zweite Seite (10b) münden, um so wenigstens die besagte opake metallische Schicht (9) in eine Reihe von kontinuierlichen Streifen (9a) zu teilen.

4. Zelle nach einem der vorstehenden Ansprüche, dadurch gekennzeichnet, dass die besagten Öffnungen (11, 13) sich durch die Halbleiterschicht (7) erstrecken.

5. Zelle nach Anspruch 1, dadurch gekennzeichnet, dass die besagten Transparenzöffnungen (11, 13) durch die besagte opake metallische Schicht (9) und im wesentlichen in ihrer Fortsetzung durch die besagte photovoltaische Umwandlungsschicht (7) gebildet sind, welche an den besagten Öffnungen eine Schulter (41) aufweist, die die elektrische Isolierung zwischen den besagten transparenten bzw. opaken metallischen Schichten (5, 9) verbessert.

6. Zelle nach Anspruch 5, dadurch gekennzeichnet, dass die besagte Isolierungsschulter (41), die einen Vorsprung zum Inneren der jeweiligen Öffnung (11, 13) bildet, sich kontinuierlich entlang deren gesamten Rand erstreckt.

7. Zelle nach Anspruch 5 oder 6, dadurch gekennzeichnet, dass die Isolierungsschulter (41) eine Breite zwischen etwa 5 und 50 Mikron aufweist.

8. Zelle nach Anspruch 1, bei der die besagte photovoltaische Umwandlungsschicht (7) auf der Basis von amorphem Silicium hergestellt ist und die besagte opake metallische Schicht ein nicht oxidierbares Metall, das gegenüber Soda widerstandsfähig ist, umfaßt.

9. Solarmodul, das eine Vielzahl von photovoltaischen Einzelzellen (10, 20, 30, 40) gemäß einem der Ansprüche 1 bis 8 umfaßt, welche an den Reihenzwischenverbindungszonen (19) in Reihe elektrisch verbunden sind.

10. Modul nach Anspruch 9, bei dem sich die besagten Reihenverbindungszonen (19), welche die besagten Einzelzellen (10, 20...) in Reihe verbinden, quer zu der (den) besagten Richtung(en) erstrecken, in der (denen) die Gräben (13) längsorientiert sind.

11. Modul nach Anspruch 9, bei dem sich die besagten Gräben in jeder Zelle bis in die Nähe der beiden gegenüberliegenden Seiten (10a, 10b) der jeweiligen Zelle erstrecken.

12. Modul nach Anspruch 9 oder 10, bei dem die besagten Gräben (13) zwei gegenüberliegende Längsenden aufweisen, die in eine erste Seite (10a) bzw. eine gegenüberliegende zweite Seite (10b) jeder Zelle münden.

13. Modul nach einem der Ansprüche 9 bis 12, bei dem der Abstand (l₁) zwischen zwei der besagten benachbarten Öffnungen (11, 13) kleiner oder gleich etwa 2 mm oder 2,5 mm ist, so dass ein menschliches Auge im wesentlichen klar durch das Modul hindurchschauen kann.

14. Modul nach Anspruch 9, bei dem die besagten Transparenzgräben (13) zweier benachbarter Einzelzellen miteinander in Paaren in einer Linie kommunizieren.

15. Modul nach einem der Ansprüche 9 bis 14, dadurch gekennzeichnet, dass es außerdem komplementäre Transparenzgräben (33) umfaßt, die sich quer zu den besagten Gräben (13) der Einzelzellen entlang wenigstens einiger der Reihenzwischenverbindungszonen (19) in Form von Streifen erstrecken, wobei die besagten komplementären Gräben in Richtung der Moduldicke durch die photovoltaische Halbleiterumwandlungsschicht (7) in Verlängerung eines anderen Schnitts gebildet sind, der durch die opake metallische Schicht (9) zur Verbindung der Zellen in Reihe gebildet ist.

16. Modul nach einem der Ansprüche 9 bis 14, der einen kontinuierlichen Umfangsgraben (35) zur elektrischen Isolierung des Moduls gegenüber seinen Kanten aufweist, wobei der besagte Umfangsgraben nicht nur durch die besagte opake metallische Schicht, sondern auch durch die photovoltaische Halbleiterumwandlungsschicht (7) gebildet ist, die in Kontakt mit dieser opaken Schicht (9) angeordnet ist, und im wesentlichen in Verlängerung durch die transparente metallische Schicht (5), die in Kontakt mit der besagten photovoltaischen Umwandlungsschicht angeordnet ist, mit einer elektrischen Isolierungsschulter (41) in Höhe des Abschnitts des Grabens, der durch diese photovoltaische Umwandlungsschicht gebildet ist, um die elektrische Isolierung zwischen den besagten metallischen Schichten (5, 9) zu verstärken.

## Claims

1. A photovoltaic cell comprising:
- an electrically insulating, transparent substrate (3),
- a stack of films stacked on the substrate, comprising a transparent metallic film (5), a semiconducting photovoltaic conversion film (7) and an opaque metallic film (9) through which openings (11, 13) are formed for passing light through said film,
- characterized in that said openings (11, 13) have a channel shape, said channels forming therebetween strips of material (9a) of the opaque metallic film,
- and in that said channels (13) extend longitudinally substantially in the direction (13a) of the photogenerated current lines circulating in said opaque metallic film (9).

2. The cell according to claim 1 characterized in that said channels extend substantially parallel to each other continuously as far as the vicinity of two opposite edges (10a, 10b) of the cell.

3. The cell according to claim 1 characterized in that said channels (13) have two opposite longitudinal ends opening into a first edge (10a) and an opposite second edge (10b) of this cell respectively, thereby dividing at least said opaque metallic film (9) into a series of continuous strips (9a).

4. The cell according to any of the previous claims characterized in that said openings (11, 13) extend through the semiconducting film (7).

5. The cell according to claim 1 characterized in that said transparency openings (11, 13) are formed through said opaque metallic film (9) and, substantially in their extension, through said photovoltaic conversion film (7) which has at the place of said openings a shoulder (41) promoting electric insulation between said transparent and opaque metallic films (5, 9).

6. The cell according to claim 5 characterized in that said insulating shoulder (41) forming a projection toward the interior of the opening (11, 13) in question extends continuously along the entire border thereof.

7. The cell according to either of claims 5 or 6 characterized in that the insulating shoulder (41) has a width between about 5 and 50 microns.

8. The cell according to claim 1 wherein said photovoltaic conversion film (7) is realized on the basis of amorphous silicon and said opaque metallic film comprises a non-oxidizing metal resistant to soda.

9. A solar module comprising a plurality of elementary photovoltaic cells (10, 20, 30, 40) according to any of claims 1 to 8 connected electrically in series at the place of series interconnection zones (19).

10. The module according to claim 9 wherein said series connection zones (19) connecting in series said elementary cells (10, 20...) extend transversely to said direction(s) in which the channels (13) are oriented longitudinally.

11. The module according to claim 9 wherein said channels extend, in each cell, as far as the vicinity of two opposite edges (10a, 10b) of the cell in question.

12. The module according to either of claims 9 or 10 wherein said channels (13) have two opposite longitudinal ends opening into a first edge (10a) and a second opposite edge (10b) of each cell respectively.

13. The module according to any of claims 9 to 12 wherein the distance (l₁) between two said adjacent openings (11, 13) is smaller than or equal to about 2 mm or 2.5 mm so that a human eye can see fairly distinctly through the module.

14. The module according to claim 9 wherein said transparency channels (13) of two adjacent elementary cells communicate with each other in pairs in a line.

15. The module according to any of claims 9 to 14 characterized in that it also comprises complementary transparency channels (33) extending transversely to said channels (13) of the elementary cells along at least some of the series interconnection zones (19) in the shape of strips, said complementary channels being formed in the direction of the module thickness through the semiconducting photovoltaic conversion film (7) in continuation of another cut formed through the opaque metallic film (9) for series connection of the cells.

16. The module according to any of claims 9 to 14 comprising a continuous peripheral channel (35) for electric insulation of the module relative to its edges, said peripheral channel being formed not only through said opaque metallic film (9) but also through the semiconducting photovoltaic conversion film (7) disposed in contact with said opaque film (9) and, substantially in its extension, through the transparent metallic film (5) disposed in contact with said photovoltaic conversion film, with an electrically insulating shoulder (41) at the level of the channel portion formed through said photovoltaic conversion film, in order to strengthen the electric insulation between said metallic films (5, 9).
